**Europäisches Patentamt**

**European Patent Office**

**Office européen des brevets**

(11) Veröffentlichungsnummer: **0 179 984 B1**

(19)

(12) **EUROPÄISCHE PATENTSCHRIFT**

(45) Veröffentlichungstag der Patentschrift: 08.05.91

(51) Int. Cl.⁵: **H03H 17/04**

(21) Anmeldenummer: **85108390.7**

(22) Anmeldetag: **06.07.85**

(54) **Digitalfilter mit beliebig einstellbarem Frequenzgang.**

(30) Priorität: 02.11.84 DE 3439977

(43) Veröffentlichungstag der Anmeldung:
07.05.86 Patentblatt 86/19

(45) Bekanntmachung des Hinweises auf die
Patenterteilung:
08.05.91 Patentblatt 91/19

(84) Benannte Vertragsstaaten:
CH DE GB LI NL

(56) Entgegenhaltungen:

1978 IEEE INTERNATIONAL SYMPOSIUM ON
CIRCUITS AND SYSTEMS PROCEEDINGS,
New York, 17.-19. Mai 1978, Seiten 289-296,
IEEE, US; Z. ALI: "A configurable parallel
arithmetic structure for recursive digital filtering"

IEEE TRANSACTIONS ON CIRCUITS AND SY-
STEMS, Band CAS-26, Nr. 3, März 1979, Seiten 149-153, IEEE, New York, US; L.B. JACK-
SON et al.: "Optimal synthesis of second-
order state-space structures for digital filters"

IEEE TRANSACTIONS ON CIRCUITS AND SY-

STEMS, Band CAS-31, Nr. 7, Juli 1984, Seiten
602-608, IEEE, New York, US; C.W. BARNES:
"On the design of optimal state-space realizations of second-order digital filters"

(73) Patentinhaber: ANT Nachrichtentechnik GmbH
Gerberstrasse 33
W-7150 Backnang(DE)

(72) Erfinder: Göckler, Heinz, Dipl.-Ing.
Elbinger Strasse 52
W-7150 Backnang(DE)

Anmerkung: Innerhalb von neun Monaten nach der Bekanntmachung des Hinweises auf die Erteilung des
europäischen Patents kann jedermann beim Europäischen Patentamt gegen das erteilte europäische Patent
Einspruch einlegen. Der Einspruch ist schriftlich einzureichen und zu begründen. Er gilt erst als eingelegt, wenn
die Einspruchsgebühr entrichtet worden ist (Art. 99(1) Europäisches Patentübereinkommen).

**Beschreibung**

Die Erfindung betrifft ein Digitalfilter mit beliebig einstellbarem Frequenzgang gemäß Oberbegriff des Anspruchs 1.

Solche Digitalfilter sind bekannt, beispielsweise durch den Aufsatz von DEL RE und DE VIDI "A PRACTICAL METHOD OF COEFFICIENT COMPUTATION FOR A MICROPROCESSOR-CONTROLLED VARIABLE RECURSIVE DIGITAL FILTER" in Signal Processing 2 (1980), Seite 283 bi 287.

Nachteilig ist bei den vorbekannten Lösungen, daß die Bestimmungen der Koeffizienten zu kompliziert ist, daß die Anzahl der Koeffizienten zu groß ist und daß dadurch große Speicherkapazität erforderlich ist. Hinzu kommt daß für manche Frequenzgangeinstellungen die Koeffizientenempfindlichkeit und damit die erforderliche Koeffizientenwortlänge zu groß ist.

Der Erfindung lag deshalb die Aufgabe zugrunde, ein Digitalfilter der eingangs genannten Art anzugeben, bei dem die Koeffizienten auf einfachere Art berechnet werden können und bei dem die Anzahl der zu berechnenden und abzuspeichernden Koeffizientenwerte verringert ist. Außerdem sollen Koeffizientenempfindlichkeit und -wortlänge für beliebige Frequenzgangeinstellungen klein sein.

Die Lösung dieser Aufgabe erfolgt durch die in den Ansprüchen 1 bis 3 gekennzeichneten Merkmale.

Zwar ist die Parallelform digitaler Filter an sich bekannt, beispielsweise durch das Buch von S.A. Tretter "Introduction to discrete-time signal processing", New York, John Wiley, 1976. Auch die Zustandsraumstruktur mit geringer Koeffizientenempfindlichkeit ist an sich bekannt durch den Aufsatz von Barnes "On the Design of Optimal State-Space Realizations of Second-Order Digital Filters", IEEE TRANSACTIONS ON CIRCUITS AND SYSTEMS, Vol. CAS-31, No. 7, July 1984.

Durch die erfindungsgemäßen Vorschriften für die Koeffizienten in den Blöcken des ersten bzw. zweiten Grades ergeben sich die Vorteile einer deutlichen Aufwandsminderung für die eingangs genannten Digitalfilter, vor allem bei der Verwendung in einem extrem großen Variationsbereich.

Es folgt nun die Beschreibung der Erfindung anhand der Figuren.

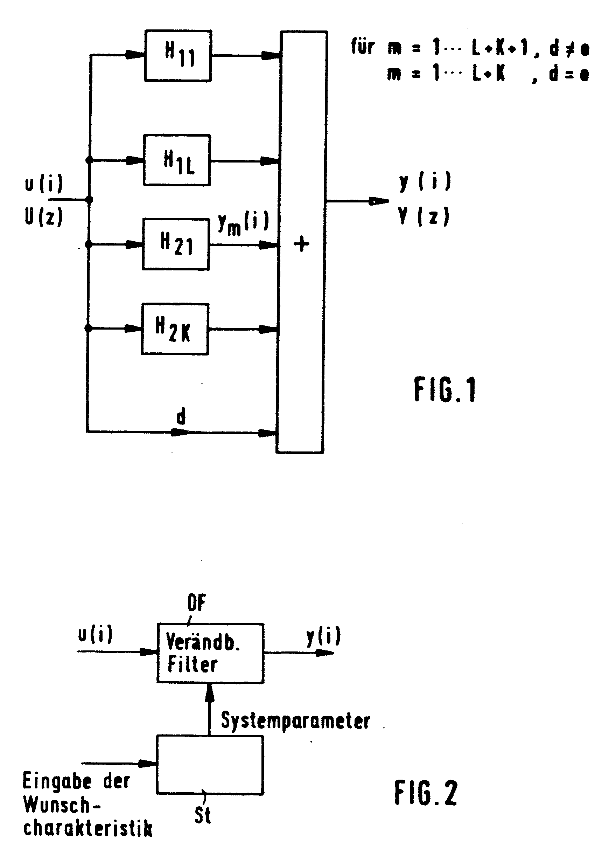

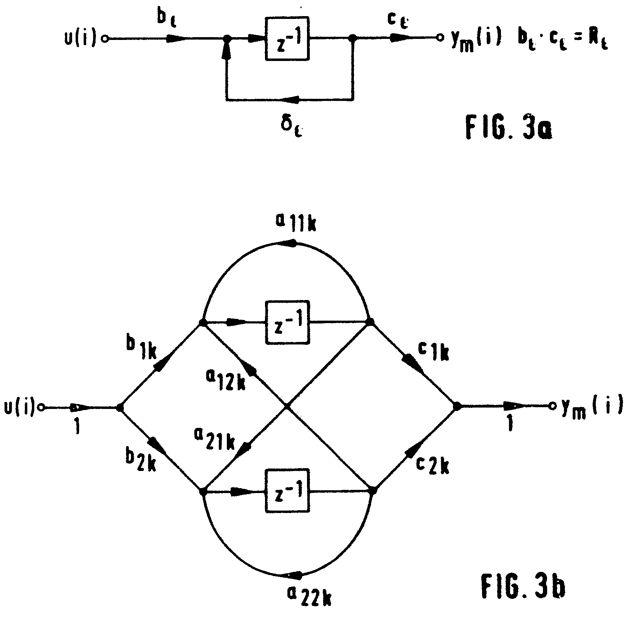

Die Figur 1 zeigt das Blockschaltbild eines Digitalfilters in Parallelform. Die Figur 2 zeigt die allgemeine Struktur eines veränderbaren Digitalfilters. In Figur 3 ist ein detailliertes Blockschaltbild für einen Block des ersten bzw. zweiten Grades für ein Ausführungsbeispiel dargestellt.

In Figur 1 ist eine Anzahl eingradiger Blöcke H11 bis H1L sowie eine Anzahl zweigradiger Blöcke H21 bis H2K erkennbar, welche mit dem Eingangssignal u(i) gespeist werden und deren Ausgangssignale sowie das mit d bewertete Eingangssignal mittels eines Summierers zum Ausgangssignal y(i) zusammengefaßt werden. Die Übertragungsfunktion dieses Filters ist

$$H(z) = Y(z)/U(z) = d + \sum_{l=1}^{L} H1l(z) + \sum_{k=1}^{K} H2k(z).$$

Für die Blöcke erster Ordnung ist die Übertragungsfunktion $H1l(z) = Rl/(z - z\infty 1)$ für $l = 1 \ldots L$ mit dem Residuum $Rl \in R$ und $Z\infty l \epsilon R$. Für die K Blöcke zweiter Ordnung gilt $H2K(z) = Rk/(z - z\infty k) + Rk*/(z - z\infty *k)$ mit $z\infty k = \rho k \cdot \cos \Theta k + j \rho k \sin\Theta k$ und $z\infty *k = \rho\cos \Theta k - j\rho k \sin \Theta k$.

Dabei sind $\rho k$ = Betrag und $\Theta k$ = Winkel der komplexen Polstelle in der z-Ebene und $Rk = Rkr + jRki$ das komplexe Residuum, wobei der Index r für den Realteil und der Index i für den Imaginärteil stehen. Das konjugiert komplexe Residuum ist $Rk* = Rkr - jRki$.

In Figur 2 ist ein veränderbares Filter DF mit den Eingangsgrößen u(i) und Ausgangsgröße y(i) erkennbar. Mit Hilfe einer Steuerung St werden die Systemparameter zur Veränderung des digitalen Filters in dasselbe eingegeben. Die Steuerung kann entweder als Massenspeicher realisiert sein, in welchem all die verschiedenen Systemparameter eingespeichert sind, oder die Steuerung kann als Koeffizientenrechner realisiert sein, in dem durch Eingabe einer Wunschcharakteristik die verschiedenen Koeffizienten errechnet werden.

Für veränderbare Digitalfilter gemäß Figur 2, wie sie auch in dem oben aufgeführten Aufsatz von DEL RE und DE VIDI beschrieben sind, gelten die folgenden Systemanforderungen:

1. Die Systemeigenschaften (Frequenzgang) sollen nur durch wenige Systemparameter festlegbar sein, dadurch wird die benötigte Kapazität für den Massenspeicher bzw. der Aufwand für die zu berechnenden Parameter kleiner.

2. Die Berechnung der Systemparameter soll einfach, d.h. durch einen einfachen Algorithmus durchführbar sein.

3. Die Systemeigenschaften sollen über extreme Bereiche variierbar sein, wozu eine geringe Koeffizientenempfinlichkeit und damit gute Rauscheigenschaften über den gesamten Variationsbereich erforderlich sind.

4. Die Filterteilsysteme sollen so realisiert werden, daß sie frei sind von parasitären Schwingungen (Überlaufschwingungen, Grenzzyklen), da wegen der Veränderbarkeit mit unerwarteten Störeffekten gerechnet werden muß, insbesondere beim Umschalten während des Betriebs.

Es sind Zustandsraumstrukturen für Filter bekannt, welche die Forderungen 3 und 4 mit der Globalstruktur von Figur 1 erfüllen, siehe Teilsysteme zweiter Ordnung nach Barnes. Diese benötigen jedoch viele Multiplizierer, und von deren Koeffizienten unterscheiden sich fast alle.

Die Figuren 3a und b zeigen bekannte empfindlichkeitsoptimale Zustandsraumstrukturen für Blöcke ersten und zweiten Grades. Die Koeffizienten des Teilsystems der zweiten Ordnung gemäß Figur 3b berechnen sich dabei nach Barnes. Dabei treten sieben verschiedene Koeffizienten auf; beim Block der ersten Ordnung sind es drei verschiedene Koeffizientenwerte.

Der Block ersten Grades des erfindungsgemäßen Digitalfilters hat den Vorteil, daß nur zwei variable, leicht bestimmbare Koeffizienten erforderlich sind. Beim Teilsystem der zweiten Ordnung sind nur vier betragsmäßig unterschiedliche Koeffizientenwerte zu berechnen, wobei die Bedingungen für optimale Empfindlichkeit $a11k = a22k$ und $b1k \cdot c1k = b2k \cdot c2k$ nach Barnes erfüllt sind und somit auch ein günstiges Rauschverhalten für beliebige Koeffizienteneinstellungen vorhanden ist.

Es ist zu beachten, daß durch jede Art von Skalierung die eben genannten Eigenschaften minimaler Anzahl von Koeffizientenspeicherplätzen verloren geht. Deshalb ist im Falle einer Festkommarealisierung die Koeffizientenwortlänge den unskalierten Koeffizientenwerten geeignet anzupassen bzw. groß genug für den zu erwartenden Filtervariationsbereich zu wählen. Im Falle einer Gleitkommarealisierung ist hierauf keine Rücksicht zu nehmen, da sich derartige Systeme selbst skalieren bzw. keine explizite Skalierung benötigen.

In Figur 3a ist ein Block erster Ordnung dargestellt, bestehend aus einem Verzögerungsglied VZ, welches gemäß der Funktion $z^{-1}$ um eine Taktzeit verzögert und welches eine Eigenrückkopplung aufweist, welche mit dem Koeffizientenwert $\delta1$ bewertet ist. Die Eingangsgröße $u(i)$ wird mit dem Koeffizientenwert bl bewertet, mit der Eigenrückkopplung mittels Addierer addiert und anschließend dem Eingang des Verzögerungsgliedes VZ zugeführt. Der Ausgangswert des Verzögerungsgliede ergibt mit dem Koeffizientenwert cl bewertet die Ausgangsgröße $ym(i)$.

Die Figur 3b zeigt einen Block zweiter Ordnung, enthaltend zwei Verzögerungsglieder VZ1 und VZ2, die jeweils eine Eigenrückkopplung, mit a11k bzw. a22k bewertet, und eine wechselseitige Rückkopplung vom Ausgang des einen auf den Eingang des jeweils anderen Verzögerungsgliedes, mit a12k bzw. a21K bewertet aufweisen, sowie zwei Summierer, durch welche das Eingangssignal $u(i)$, mit b1k bzw. b2k bewertet, mit den Rückkopplungswerten summiert wird, und ein Addierer, durch welchen die Ausgangswerte der Verzögerungslieder mit einem Koeffizientenwert c1k bzw. c2k bewertet zum Ausgangssignal $ym(i)$ addiert werden.

Die Koeffizientenwerte beim Block erster Ordnung sind nun entweder bl = Rl und cl identisch = 1 oder bl identisch = 1 und cl = Rl, wobei Rl wie eingangs erwähnt das Residuum ist.

Für Figur 3b gelten die folgenden vier Varianten:

$$a11k = a22k = \rho k \cdot \cos \theta k = \text{Realteil} (z \infty k)$$

$$a21k = -a12k = \rho k \cdot \sin \theta k = \text{Imaginärteil} (z \infty k)$$

$$b1k = c2k = \pm \sqrt{|Rk| - Rki}$$

$$b2k = c1k = \pm \text{sign} (Rkr) \cdot \sqrt{|Rk| + Rki}$$

$$a11k = a22k = \rho k \cos \theta k$$

$$a12k = -a21k = \rho k \sin \theta k$$

$$b1k = -c2k = \pm \sqrt{|Rk| - Rki}$$

$$b2k = -c1k = \mp \text{sign} (Rkr) \sqrt{|Rk| + Rki}$$

$$a11k \; = \; a22k \; = \; \varrho k \, \cos \Theta k$$

$$a12k \; = \; -a21k \; = \; \varrho k \, \sin \Theta k$$

$$b1k \; = \; c2k \; = \; \pm \, \text{sign} \, (Rkr) \sqrt{|Rk| + Rki}$$

$$b2k \; = \; c1k \; = \; \pm \, \sqrt{|Rk| - Rki} \quad \text{und}$$

$$a11k \; = \; a22k \; = \; \varrho k \, \cos \Theta k$$

$$a21k \; = \; -a12k \; = \; \varrho k \, \sin \Theta k$$

$$b1k \; = \; -c2k \; = \; \pm \, \text{sign} \, (Rkr) \sqrt{|Rk| + Rki}$$

$$b2k \; = \; -c1k \; = \; \mp \sqrt{|Rk| - Rki}.$$

## Ansprüche

1. Digitalfilter mit beliebig einstellbarem Frequenzgang, mit Multiplizierern, Addierern und/oder Summierern und Verzögerungsgliedern in Parallelstruktur mit L Blöcken ersten Grades, die als Zustandsvariablenfilter (Zustandsraumfilter) ausgeführt sind, dadurch gekennzeichnet, daß einer der Eingangs- (bl) oder Ausgangskoeffizienten (cl) des Verzögerungsgliedes (VZ) für beliebige Filtereinstellungen identisch gleich Eins ist und daß diejenigen Eingangs- (bl) oder Ausgangskoeffizienten (cl), die nicht identisch Eins sind, entsprechend der Bemessungsregel bl . cl = Rl mit dem Wert des Residuums Rl bemessen werden.

2. Digitalfilter mit beliebig einstellbarem Frequenzgang, mit Multiplizierern, Addierern und/oder Summierern und Verzögerungsgliedern in parallelstruktur mit K Blöcken zweiten Grades, die als Zustandsvariablenfilter (zustandsraumfilter) ausgeführt sind, gekennzeichnet durch die Kombination der fclgenden Merkmale:

   a) Jeweils von den acht Koeffizienten sind zwei betragsgleich, wobei das Produkt aus Eingangs- und Ausgangskoeffizienten (b1k . c1k, b2k . c2k) bei beiden Verzögerungsgliedern (VZ1, VZ2) gleich ist und die Koeffizienten (a12k, a21k) des Rekursivteils für die wechselseitige Rückkopplung der Verzögerungsglieder (VZ1, VZ2) betragsgleich und vorzeichenungleich sind und die Koeffizienten (a11k, a22k) für die Eigenrückkopplung der Verzögerungsglieder (VZ1, VZ2) gleich sind, und
   b) die Eingangskoeffizienten (b1k, b2k) der Verzögerungsglieder (VZ1, VZ2) sind jeweils betragsgleich den Ausgangskoeffizienten (c2k, c1k) des jeweils anderen Verzögerungsgliedes (VZ2, VZ1).

3. Digitalfilter mit beliebig einstellbarem Frequenzgang, mit Multiplizierern, Addierern und/oder Summierern und Verzögerungsgliedern in Parallelstruktur mit L Blöcken ersten Grades und K Blöcken zweiten Grades, die als Zustandsvariablenfilter (zustandsraumfilter) ausgeführt sind, gekennzeichnet durch die Kombination der folgenden Merkmale:

   a) daß bei den Blöcken ersten Grades einer der Eingangs- (bl) oder Ausgangskoeffizienten (cl) des Verzögerungsgliedes (VZ) für beliebige Filtereinstellungen identisch gleich Eins, und daß diejenigen Eingangs- (bl) oder Ausgangskoeffizienten (cl), die nicht identisch Eins sind, entsprechend der Bemessungsregel bl . cl = Rl mit dem Wert des Residuums Rl bemessen werden,
   b) daß bei den Blöcken des zweiten Grades jeweils von den acht Koeffizienten zwei betragsgleich sind, wobei das Produkt aus Eingangs- und Ausgangskoeffizienten (b1k . c1k, b2k . c2k) bei beiden Verzögerungsgliedern (VZ1, VZ2) gleich ist und die Koeffizienten (a12k, a21k) des Rekursivteils für die wechselseitige Rückkopplung der Verzögerungsglieder (VZ1, VZ2) betragsgleich und vorzeichenungleich sind und die Koeffizienten (a11k, a22k) für die Eigenrückkopplung der Verzögerungsglieder (VZ1, VZ2) gleich sind, und
   c) daß die Eingangskoeffizienten (b1k, b2k) der Verzögerungsglieder (VZ1, VZ2) bei den Blöcken

4

des zweiten Grades jeweils betragsgleich den Ausgangskoeffizienten (c2k, c1k) des jeweils anderen Verzögerungsgliedes (VZ2, VZ1) sind.

4. Digitalfilter nach Anspruch 2 oder 3, dadurch gekennzeichnet, daß die Koeffizienten für die Blöcke des zweiten Grades folgendermaßen festgelegt sind: Der Betragswert der Koeffizienten des Rekursivteils für die Eigenrückkopplung (a11k, a22k) der Verzögerungsglieder (VZ1, VZ2) ist gleich dem Realteil der Polstelle im z-Bereich, der Betragswert der Koeffizienten des Rekursivteils für die wechselseitige Rückkopplung (a12k, a21k) der Verzögerungsglieder (VZ1, VZ2) ist gleich dem Imaginärteil der Polstelle im z-Bereich, die Betragswerte der Eingangs- (b1k, b2k) und Ausgangskoeffizienten (c1k, c2k) der Verzögerungsglieder (VZ1, VZ2) sind ausschließlich durch die Residuen der Partialbruchzerlegung der Übertragungsfunktion (Transmittanz) oder Wirkungsfunktion, $(H(z) = Y(z)/U(z))$ bestimmt.

5. Digitalfilter nach Anspruch 4, dadurch gekennzeichnet, daß die Koeffizienten die folgenden Werte aufweisen:

$$a11k = a22k = \rho k \cdot \cos \theta k$$
$$a21k = -a12k = \rho k \cdot \sin \theta k$$
$$b1k = c2k = \pm \sqrt{|Rk| - Rki}$$
$$b2k = c1k = \pm \, \text{sign} \, (Rkr) \cdot \sqrt{|Rk| + Rki}.$$

6. Digitalfilter nach Anspruch 4, dadurch gekennzeichnet, daß die Koeffizienten die folgenden Werte aufweisen:

$$a11k = a22k = \rho k \cdot \cos \theta k$$
$$a12k = -a21k = \rho k \cdot \sin \theta k$$
$$b1k = -c2k = \pm \sqrt{|Rk| - Rki}$$
$$b2k = -c1k = \mp \, \text{sign} \, (Rkr) \cdot \sqrt{|Rk| + Rki}.$$

7. Digitalfilter nach Anspruch 4, dadurch gekennzeichnet, daß die Koeffizienten die folgenden Werte aufweisen:

$$a11k = a22k = \rho k \cdot \cos \theta k$$
$$a12k = -a21k = \rho k \cdot \sin \theta k$$
$$b1k = c2k = \pm \, \text{sign} \, (Rkr) \cdot \sqrt{|Rk| + Rki}$$
$$b2k = c1k = \pm \sqrt{|Rk| - Rki}.$$

8. Digitalfilter nach Anspruch 4, dadurch gekennzeichnet, daß die Koeffizienten die folgenden Werte aufweisen:

5

$$a11k = a22K = \rho k \cdot \cos \Theta k$$
$$a21k = -a12k = \rho k \cdot \sin \Theta k$$
$$b1k = -c2k = \pm \text{ sign } (Rkr) \sqrt{|Rk| + Rki}$$
$$b2k = -c1k = \mp \sqrt{|Rk| - Rki.}$$

9. Digitalfilter nach einem der vorhergehenden Ansprüche, dadurch gekennzeichnet, daß seine Signalverarbeitung in den Multiplizierern, Summierern oder Addierern und Verzögerungsgliedern in Gleitkommaarithmetik erfolgt.

## Claims

1. Digitial filter with an arbitrarily settable frequency response, with multipliers, adders and/or summators and delay members in parallel structure with L blocks of first order, which are constructed as state-variable filter (phase state filters), characterised thereby, that one of the input co-efficients (bl) or output co-efficients (cl) of the delay member (VZ) is equal to unity for arbitrary filter settings and that those input co-efficients (bl) or output co-efficients (cl), which are not equal to unity, are dimensioned with the value of the remainder Rl according to the proportioning rule Bl.cl = Rl.

2. Digital filter with an arbitrarily settable frequency response, with multipliers, adders and/or summators and delay members in parallel structure with K blocks of second order, which are constructed as state-variable filters (phase state filters), characterised by the combination of the following features:
   a) of the eight co-efficients, two are quantitatively equal, wherein the product of input co-efficients and output co-efficients (b1k. c1k, b2k.c2k) is equal for both delay members (VZ1, VZ2) and the co-efficients (a12k, a21k) of the recursive part for the reciprocal feedback of the delay members (VZ1, VZ2) are quantitatively equal and of the same sign and the co-efficient (a11k, a22k) for the internal feedback of the delay members (VZ1, VZ2) are equal and
   b) the input co-efficients (b1k, b2k) of the delay members (VZ1, VZ2) are each quantitatively equal to the output co-efficients (c2k, c1k) of the respective other delay member (VZ2, VZ1).

3. Digital filter with an arbitrarily settable frequency response, with multipliers, adders and/or summators and delay members in parallel structure with L blocks of first order and K blocks of second order, which are constructed as state-variable filters (phase state filters), characterised by the combination of the following features:
   a) one of the input co-efficients (bl) or output co-efficients (cl) of the delay member (VZ) in the blocks of first order is equal to unity for arbitrary filter settings and that those input co-efficients (bl) or output co-efficients (cl), which are not equal to unity, are dimensioned with the value of the remainder Rl according to the proportioning rule bl.cl = Rl,
   b) of the eight co-efficients, two are quantitatively equal in the blocks of the second order, wherein the product of input co-efficients and output co-efficients (b1k. c1k, b2k.c2k) is equal for both delay members (VZ1, VZ2) and the co-efficients (a12k, a21k) of the recursive part for the reciprocal feedback of the delay members (VZ1, VZ2) are quantitatively equal and of the same sign and the co-efficients (a11k, a22k) for the internal feedback of the delay members (VZ1, VZ2) are equal and
   c) the input co-efficients (b1k, b2k) of the delay members (VZ1, VZ2) in the blocks of the second order are each quantitatively equal to the output co-efficients (c2k, c1k) of the respective other delay member (VZ2, VZ1).

4. Digital filter according to claim 2 or 3, characterised thereby, that the co-efficients for the blocks of the second order are fixed in the following manner:
   The quantitative value of the co-efficients of the recursive part for the internal feedback (a11k, a22k) of the delay members (VZ1, VZ2) is equal to the real part of the pole point in the z-region, the quantitative value of the co-efficients of the recursive part for the reciprocal feedback (a12k, a21k) of the delay members (VZ1, VZ2) is equal to the imaginary part of the pole point in the z-region, the quantitative values of the input co-efficients (b1k, b2k) and output co-efficients (c1k, c2k) of the delay members

EP 0 179 984 B1

(VZ1, VZ2) are determined exclusively by the remainders of the decomposition to partial fractions of the transmission function (transmittance) or the characteristic function (H(z) = Y(z)/U(z)).

5. Digital filter according to claim 4, characterised thereby, that the co-efficients display the following values:

$$
\begin{aligned}
a11k = a22k &= \rho k \quad . \quad \cos \Theta k \\
a21k = -a12k &= \rho k \quad . \quad \sin \Theta k \\
b1k \quad = c2k \quad &= \pm \sqrt{|Rk| - Rki} \\
b2k \quad = c1k \quad &= \pm \operatorname{sign} (Rkr) \cdot \sqrt{|Rk| + Rki.}
\end{aligned}
$$

6. Digital filter according to claim 4, characterised thereby, that the co-efficients display the following values:

$$
\begin{aligned}
a11k = a22k &= \rho k \quad . \quad \cos \Theta k \\
a12k = -a21k &= \rho k \quad . \quad \sin \Theta k \\
b1k \quad = -c2k \quad &= \pm \sqrt{|Rk| - Rki} \\
b2k \quad = -c1k \quad &= \mp \operatorname{sign} (Rkr) \cdot \sqrt{|Rk| + Rki.}
\end{aligned}
$$

7. Digital filter according to claim 4, characterised thereby, that the co-efficients display the following values:

$$
\begin{aligned}
a11k = a22k &= \rho k \quad . \quad \cos \Theta k \\
a12k = -a21k &= \rho k \quad . \quad \sin \Theta k \\
b1k \quad = c2k \quad &= \pm \operatorname{sign} (Rkr) \cdot \sqrt{|Rk| + Rki} \\
b2k \quad = c1k \quad &= \pm \sqrt{|Rk| - Rki.}
\end{aligned}
$$

8. Digital filter according to claim 4, characterised thereby, that the co-efficients display the following values:

$$
\begin{aligned}
a11k = a22K &= \rho k \quad . \quad \cos \Theta k \\
a21k = -a12k &= \rho k \quad . \quad \sin \Theta k \\
b1k \quad = -c2k \quad &= \pm \operatorname{sign} (Rkr) \sqrt{|Rk| + Rki} \\
b2k \quad = -c1k \quad &= \mp \sqrt{|Rk| - Rki.}
\end{aligned}
$$

9. Digital filter according to one of the preceding claims, characterised thereby, that its signal processing in the multipliers, summators or adders and delay members takes place in floating decimal point arithmetic.

7

**EP 0 179 984 B1**

**Revendications**

1. Filtre numérique à réponse en fréquences réglable à volonté, avec des multiplicateurs, des additionneurs et/ou des sommateurs et des éléments de retard en structure parallèle avec L blocs de premier degré, qui sont réalisés sous forme de filtres de variables d'état (filtres d'espace d'état), caractérisé en ce que l'un des coefficients d'entrée (b1) ou de sortie (c1) de l'élément de retard (vz) est identique à un pour des réglages de filtre quelconques et en ce que les coefficients d'entrée (b1) ou de sortie (c1) qui ne sont pas identiques à un sont calculés selon la règle de calcul b1 . c1 = R1 avec la valeur du résidu R1.

2. Filtre numérique à réponse en fréquences réglable à volonté, avec des multiplicateurs, des additionneurs et/ou des sommateurs et des éléments de retard en structure parallèle avec K blocs de deuxième degré, qui sont réalisés sous forme de filtres de variables d'état (filtres d'espace d'état), caractérisé par la combinaison des caractéristiques suivantes :
   a) deux des huit coefficients sont à chaque fois identiques en valeur absolue, le produit des coefficients d'entrée et de sortie (b1k . c1k, b2k . c2k) pour les deux éléments de retard (VZ1, VZ2) étant égal et les coefficients (a12k, a21k) de la partie récurrente pour la rétroaction réciproque des éléments de retard (VZ1, VZ2) étant de valeurs absolues et de signes identiques et les coefficients (a11k, a22k) pour la rétroaction propre des éléments de retard (VZ1, VZ2) étant égaux, et
   b) les coefficients d'entrée (b1k, b2k) des éléments de retard (VZ1, VZ2) étant à chaque fois de valeurs absolues identiques aux coefficients de sortie (c2k, c1k) de chacun des autres éléments de retard (VZ2, VZ1).

3. Filtre numérique à réponse en fréquences réglable à volonté, avec des multiplicateurs, des additionneurs et/ou des sommateurs et des éléments de retard en structure parallèle avec L blocs de premier degré et K blocs de deuxième degré, qui sont réalisés sous forme de filtres de variables d'état (filtres d'espace d'état), caractérisé par la combinaison des caractéristiques suivantes :
   a) dans les blocs de premier degré, l'un des coefficients d'entrée (b1) ou de sortie (c1) de l'élément de retard (VZ) est identique à un pour des réglages de filtre quelconques, et les coefficients d'entrée (b1) ou de sortie (c1), qui ne sont pas identiques à un, sont calculés selon la règle de calcul b1 . c1 = R1 avec la valeur du résidu R1,
   b) dans les blocs du deuxième degré, parmi les huit coefficients, deux sont de valeurs absolues identiques à chaque fois, le produit des coefficients d'entrée et de sortie (b1k . c1k, b2k . c2k) étant égal pour les deux éléments de retard (VZ1, VZ2) et les coefficients (a12k, a21k) de la partie récurrente pour la rétroaction réciproque des éléments de retard (VZ1, VZ2) sont égaux en valeur absolue et en signe et les coefficients (a11k, a22k) pour la rétroaction propre des éléments de retard (VZ1, VZ2) sont égaux, et
   c) les coefficients d'entrée (b1k, b2k) des éléments de retard (VZ1, VZ2) pour les blocs du deuxième degré sont chacun égaux en valeur absolue aux coefficients de sortie (c2k, c1k) de chacun des autres éléments de retard (VZ2, VZ1).

4. Filtre numérique selon la revendication 2 ou 3, caractérisé en ce que les coefficients pour les blocs du deuxième degré sont déterminés de la façon suivante : la valeur absolue des coefficients de la partie récurrente pour la rétroaction propre (a11k, a22k) des éléments de retard (VZ1, VZ2) est égale à la partie réelle de la position polaire dans le domaine z, la valeur absolue des coefficients de la partie récurrente pour la rétroaction réciproque (a12k, a21k) des éléments de retard (VZ1, VZ2) est identique à la partie imaginaire de la position polaire dans le domaine z, les valeurs absolues des coefficients d'entrée (b1k, b2k) et de sortie (c1k, c2k) des éléments de retard (VZ1, VZ2) sont déterminées exclusivement par les résidus de la décomposition en éléments simples de la fonction de transfert (transmittance) ou fonction principale d'Hamilton, ($H(z) = Y(z)/U(z)$).

5. Filtre numérique selon la revendication 4, caractérisé en ce que les coefficients présentent les valeurs suivantes :

8

$$a11k = a22k = \mathit{s}k \cdot \cos \theta k$$
$$a21k = -a12k = \mathit{p}k \cdot \sin \theta k$$
$$b1k = c2k = \pm \sqrt{|Rk| - Rki}$$
$$b2k = c1k = \pm \, sign \, (Rkr) \cdot \sqrt{|Rk| + Rki}.$$

6. Filtre numérique selon la revendication 4, caractérisé en ce que les coefficients présentent les valeurs suivantes :

$$a11k = a22k = \mathit{s}k \cdot \cos \theta k$$
$$a12k = -a21k = \mathit{s}k \cdot \sin \theta k$$
$$b1k = -c2k = \pm \sqrt{|Rk| - Rki}$$
$$b2k = -c1k = \mp \, sign \, (Rkr) \cdot \sqrt{|Rk| + Rki}.$$

7. Filtre numérique selon la revendication 4, caractérisé en ce que les coefficients présentent les valeurs suivantes :

$$a11k = a22k = \mathit{s}k \cdot \cos \theta k$$
$$a12k = -a21k = \mathit{s}k \cdot \sin \theta k$$
$$b1k = c2k = \pm \, sign \, (Rkr) \cdot \sqrt{|Rk| + Rki}$$
$$b2k = c1k = \pm \sqrt{|Rk| - Rki}.$$

8. Filtre numérique selon la revendication 4, caractérisé en ce que les coefficients présentent les valeurs suivantes :

$$a11k = a22k = \mathit{s}k \cdot \cos \theta k$$
$$a21k = -a12k = \mathit{s}k \cdot \sin \theta k$$
$$b1k = -c2k = \pm \, sign \, (Rkr) \sqrt{|Rk| + Rki}$$
$$b2k = -c1k = \mp \sqrt{|Rk| - Rki}.$$

9. Filtre numérique selon l'une des revendications précédentes, caractérisé en ce que son traitement des signaux a lieu dans les multiplicateurs, les sommateurs ou les additionneurs et les éléments de retard en arithmétique en virgule flottante.

9

für $m = 1 \cdots L+K+1 , d \neq 0$
$m = 1 \cdots L+K , d = 0$

**FIG.1**

**FIG.2**

FIG. 3a

FIG. 3b